# EUROPÄISCHE PATENTSCHRIFT

(11) **EP 2 677 663 B1**
(45) Veröffentlichungstag und Bekanntmachung des Hinweises auf die Patenterteilung: **20.02.2019**
(21) Anmeldenummer: 13161589.0
(22) Anmeldetag: 28.03.2013
(51) Int. Cl.: H04B 1/10, G01R 29/26, H03G 3/34, G10L 25/78

(54) **PEGEL-RAUSCHSPERRE MIT HOHER IMMUNITÄT GEGENÜBER PULSSTÖRUNGEN**
NOISE LEVEL BARRIER WITH HIGH IMMUNITY TO PULSED INTERFERENCE
SQUELCH DE NIVEAU AVEC UNE IMMUNITÉ ÉLEVÉE CONTRE LES INTERFÉRENCES D'IMPULSIONS

(30) Priorität: 21.06.2012 DE 102012012365
(43) Veröffentlichungstag der Anmeldung: 25.12.2013
(73) Patentinhaber: Rohde & Schwarz GmbH & Co. KG, 81671 München (DE)
(72) Erfinder: Arnaoudov, Rossen, 81543 München (DE); Lipp, Friedrich, 81737 München (DE)
(74) Vertreter: Körfer, Thomas

(56) Entgegenhaltungen:
- EP-A1- 0 027 343
- DD-A1- 148 427
- DE-A1- 3 525 472
- US-A- 4 358 738

## Beschreibung

Die Erfindung betrifft eine Rauschsperre für Hochfrequenzempfänger und ein Verfahren zum Rauschsperren für Hochfrequenzempfänger.

Zur Detektion der Anwesenheit eines Nutzsignals in einem Empfangssignal wird herkömmlicherweise bei Mobilfunkgeräten oder Flugfunkgeräten das Signal-Rausch-Verhältnis des Empfangssignals untersucht. Überschreitet das Signal-Rausch-Verhältnis im Nutzband einen Schwellwert, so wird dies als Anwesenheit eines Nutzsignals detektiert.

So zeigt das deutsche Patent DE 199 37 199 A1 eine Rauschsperre für digitale Hochfrequenzempfänger, welche basierend auf dem Signal-Rausch-Verhältnis die Anwesenheit eines Nutzsignals detektiert.

Insbesondere bei Anwesenheit mehrerer Nutzsignale im Empfangssignal, welche häufig an der Grenze zwischen zwei Sendebereichen unterschiedlicher Sender auftritt, kommt es jedoch zu einem ungünstigen Signal-Rausch-Verhältnis, obwohl sogar zwei Nutzsignale im Empfangssignal enthalten sind.

Um dieser Schwierigkeit zu begegnen wird zusätzlich der Signalpegel des Trägersignals innerhalb des Nutzbandes ausgewertet. Sobald der Signalpegel einen bestimmten Wert überschreitet, wird unabhängig vom gegenwärtigen Signal-Rausch-Verhältnis die Rauschsperre deaktiviert und somit das Signal hörbar.

Die geschilderte pegelbasierte Rauschsperre ist jedoch empfindlich gegenüber Pulsstörungen. Deshalb wurde in Hochfrequenz-Performancestandards (MOPS Minimum Operational Performance Standards) im zivilen Flugfunk (ATC Air Traffic Control) die Immunität gegen kurze, immer wiederkehrende Pulsstörungen definiert. Die definierten Störimpulse weisen eine Dauer von 10ps bei einer Wiederholrate von 1kHz auf. Durch den hohen Hochfrequenz-Pegel der Impulse ergibt sich trotz des kurzen Verhältnisses der Pulsdauer zu der Pausendauer von 1% ein Pegelmittelwert weit über der Empfindlichkeitsgrenze einer pegelbasierten Rauschsperre. Diese Forderungen sind somit mit einer herkömmlichen Rauschsperre mit einer Pegeldetektion nicht zu erfüllen.

Die EP 0 027 343 A1 beschreibt eine Apparatur, bei der ein Eingangssignal in einem zweiten Signal etwas verzögert wird und das verzögerte Signal mit den Eingangssignal korreliert wird. Dadurch kann unterschieden werden, ob es sich um Lärm bzw. Rauschen, dessen Frequenzen zufällig sind und daher eine niedrige Korrelation aufweist, oder Sprache, welche eine hohe Korrelation aufweist, handelt.

Die US 4,358,738 A beschreibt ein Verfahren, um die Präsenz eines Signals im Rauschen zu detektieren.

Die DD 148 427 A1 beschreibt eine Anordnung zur Störunterdrückung in FM-Empfangsanlagen.

Die DE 35 25 472 A1 beschreibt eine Anordnung zum Detektieren und Unterdrücken impulsartiger Störungen. Dabei enthält ein Signalweg einen Spitzendetektor, einen Mittelwertbestimmer, eine Verzögerungseinheit und einen Komparator. Der Ausgang des Spitzendetektors ist über den Mittelwertbestimmer an einen ersten Eingang und über die Laufzeiteinheit an einen zweiten Eingang des Komparators angeschlossen.

Der Erfindung liegt die Aufgabe zu Grunde, eine Rauschsperre und ein Verfahren zum Rauschsperren zu schaffen, welche die Anwesenheit und die Abwesenheit von Nutzsignalen zuverlässig detektieren.

Die Aufgabe wird erfindungsgemäß für die Rauschsperre durch die Merkmale des unabhängigen Anspruchs 1 und für das Verfahren durch die Merkmale des unabhängigen Anspruchs 7 gelöst. Vorteilhafte Weiterbildungen sind Gegenstand der hierauf rückbezogenen Unteransprüche.

Eine erfindungsgemäße Rauschsperre für Hochfrequenzempfänger beinhaltet einen ersten Signaldetektor, welcher ausgebildet ist, um die Anwesenheit eines Nutzsignals in einem Empfangssignal zu detektieren. Der erste Signaldetektor beinhaltet eine Verzögerungseinrichtung, welche ausgebildet ist, um ein von dem Empfangssignal abgeleitetes Signal um eine Verzögerungszeit zu verzögern. Der erste Signaldetektor beinhaltet weiterhin einen Minimum-Detektor, welcher ausgebildet ist, um ein Minimum-Signal als Minimum des von dem Empfangssignal abgeleiteten Signals und des verzögerten von dem Empfangssignal abgeleiteten Signals zu bilden. So ist eine zuverlässige Entfernung von Störsignalen aus dem Empfangssignal möglich. Die Zuverlässigkeit der Rauschsperre wird so deutlich erhöht.

Der erste Signaldetektor beinhaltet weiterhin bevorzugt eine Mittelwertbildungs-Einrichtung, welche ausgebildet ist, um das Minimum-Signal zeitlich zu mitteln und so ein Mittelwert-Signal zu erzeugen. Der erste Signaldetektor beinhaltet bevorzugt weiterhin einen Vergleicher, welcher ausgebildet ist, um das Mittelwert-Signal mit einem ersten Schwellwert zu vergleichen. Ein Überschreiten des ersten Schwellwerts zeigt eine Anwesenheit eines Nutzsignals im Empfangssignal an. So wird durch den Vergleich eine bestimmte Signalstärke angezeigt. Hieraus wird auf die Stärke des in-Band Signals und damit auch des Nutzsignals geschlossen. So schaltet die Rauschsperre auch bei 2-Träger-Signalen (z.B. CLIMAX Flugfunk) oder bei verzerrten Signalen (z.B. von Notrufsendern) zuverlässig durch.

Vorzugsweise liegt die Verzögerungszeit zwischen 10ps und 500ps, besonders bevorzugt zwischen 20ps und 200ps, insbesondere bevorzugt zwischen 50ps und 100µs. Eine Anpassung an die jeweils zu kompensierenden Störimpulse oder ein Modulationsschema des Empfangssignals ist so möglich. Dabei wird das Signal lediglich so stark verzögert wie unbedingt notwendig, da sich bei zu langer Verzögerung eine instabile Rauschsperre, welche flattert ergeben kann. Vorzugsweise wird die Verzögerungszeit dabei in Abhängigkeit des übertragenen Signals gewählt. So können sich unterschiedliche Verzögerungszeiten in Abhängigkeit der Modulation oder der Art des Störsignals ergeben.

Die Rauschsperre beinhaltet bevorzugt zumindest eine Filtereinrichtung, welche ausgebildet ist, um ein von dem Empfangssignal abgeleitetes Signal zu filtern, bevor das Signal der Verzögerungseinrichtung zugeführt ist. So wird eine Bandbegrenzung des Signals erreicht.

Die Rauschsperre beinhaltet bevorzugt weiterhin einen zweiten Signaldetektor, welcher ausgebildet ist, um anhand eines Überschreitens eines zweiten Schwellwerts durch ein Signal-Rausch-Verhältnis des Empfangssignals eine Anwesenheit eines Nutzsignals im Empfangssignal zu detektieren. So kann eine höhere Zuverlässigkeit der Rauschsperre erreicht werden als bei Einsatz nur eines Signaldetektors.

Die Rauschsperre verfügt bevorzugt vorteilhafterweise weiterhin über einen Entscheider, welcher ausgebildet ist, um zu entscheiden, dass ein Nutzsignal im Empfangssignal vorhanden ist, wenn zumindest ein Signaldetektor ein Nutzsignal im Empfangssignal detektiert. Auch dies erhöht die Zuverlässigkeit der Rauschsperre weiter. Vorzugsweise ist der Entscheider dabei als Oder-Verknüpfung ausgebildet. Somit schaltet die Rauschsperre bei Ansprechen eines der Detektoren durch.
Die Rauschsperre beinhaltet bevorzugt weiterhin einen Stummschalter, welcher ausgebildet ist, um ein von dem Empfangssignal abgeleitetes Signal auf einen Signalausgang zu schalten, wenn zumindest ein Signaldetektor eine Anwesenheit eines Nutzsignals im Empfangssignal anzeigt. So kann zuverlässig ein Öffnen der Rauschsperre auch bei schwierigen Empfangssignalen erreicht werden.

Bei einem erfindungsgemäßen Verfahren zur Rausch-Sperrung in Hochfrequenzempfängern wird die Anwesenheit eines Nutzsignals in einem Empfangssignal auf einem Empfangskanal detektiert. Ein von dem Empfangssignal abgeleitetes Signal wird dabei um eine Verzögerungszeit verzögert. Ein Minimum-Signal wird als Minimum des von dem Empfangssignal abgeleiteten Signals und des verzögerten von dem Empfangssignal abgeleiteten Signals gebildet. So können wiederkehrende Störpulse mit hoher Energie

(Frequenzbündel, ebenfalls im Empfangskanal) wirkungsvoll unterdrückt werden.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: ein erstes Ausführungsbeispiel der erfindungsgemäßen Rauschsperre als Blockschaltbild;
- Fig. 2: ein zweites Ausführungsbeispiel der erfindungsgemäßen Rauschsperre in einer Detailansicht des Blockschaltbilds;
- Fig. 3a: ein exemplarisches Empfangssignal mit Störimpulsen;
- Fig. 3b: ein erstes von einem Empfangssignal abgeleitetes Signal im Basisband mit verbreiterten Störimpulsen;
- Fig. 3c: ein zweites von einem Empfangssignal durch zeitliche Verschiebung abgeleitetes Signal;
- Fig. 3d: das erste und zweite von dem Empfangssignal abgeleitete Signal in einer überlagerten Darstellung;
- Fig. 3e: ein aus dem ersten und zweiten abgeleiteten Signal gebildetes drittes Signal, in welchem die Störimpulse stark unterdrückt sind, und
- Fig. 4: ein erstes Ausführungsbeispiel des erfindungsgemäßen Verfahrens als Flussdiagramm.

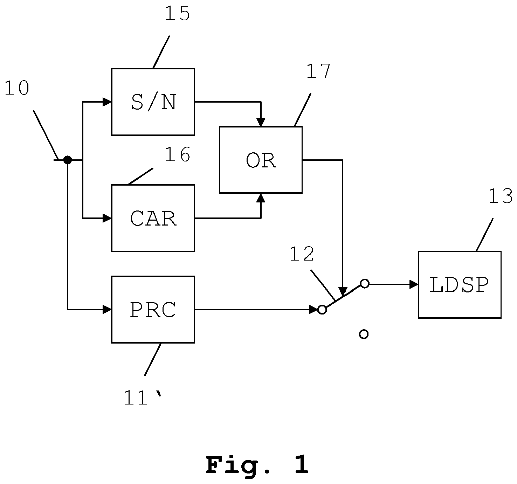

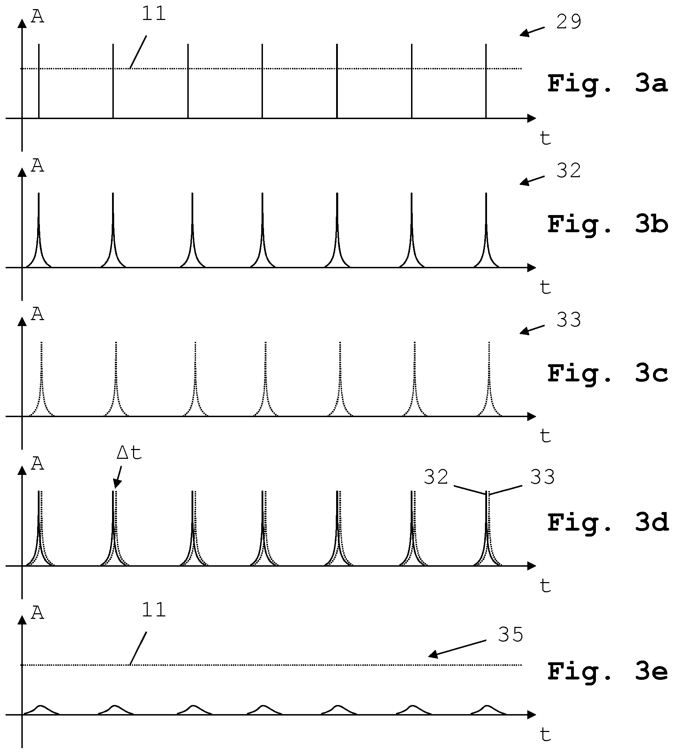

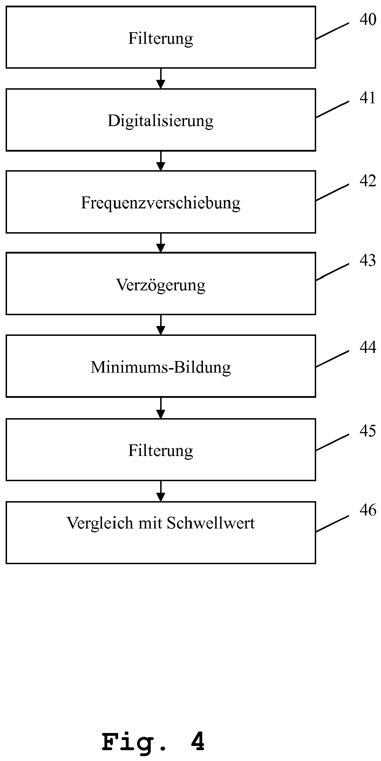

Zunächst wird anhand der Fig. 1 - 2 der Aufbau und die Funktionsweise zweier Ausführungsbeispiele der erfindungsgemäßen Rauschsperre erläutert. Mittels Fig. 3a - 3e wird auf die genaue Funktionsweise eingegangen. Anhand von Fig. 4 wird abschließend die Funktionsweise eines Ausführungsbeispiels des erfindungsgemäßen Verfahrens verdeutlicht. Identische Elemente wurden in ähnlichen Abbildungen zum Teil nicht wiederholt dargestellt und beschrieben.

Fig. 1 zeigt ein erstes Ausführungsbeispiel der erfindungsgemäßen Rauschsperre. Mit einem Eingangsanschluss 10 verbunden ist eine Verarbeitungseinrichtung 11, welche wiederum mit einem Stummschalter 12 verbunden ist. Mit dem abgewandten Ende des Stummschalters 12 verbunden ist ein Lautsprecher 13. Mit dem Eingangsanschluss 10 sind weiterhin ein erster Signaldetektor 15 und ein zweiter Signaldetektor 16 verbunden. Die Signaldetektoren 15 und 16 sind wiederum mit einem Entscheider 17 verbunden, welcher mit dem Stummschalter 12 verbunden ist. Bei der Verarbeitungseinrichtung handelt es sich dabei um einen Audioverarbeitungsblock. Dieser dient der Filterung auf einen Frequenzbereich von 30 - 2500Hz und einer Verstärkung. Der Signaldetektor 15 arbeitet dabei basierend auf dem Signal-Rausch-Verhältnis. Der Signaldetektor 16 arbeitet dabei basierend auf dem Pegel innerhalb des Nutzbandes. Der Entscheider 17 arbeitet als Oder-Verknüpfung.

An dem Eingangsanschluss 10 wird ein Empfangssignal eingespeist. Eine eventuelle Vorverarbeitung ist hier nicht dargestellt. Der erste Signaldetektor 15 und der zweite Signaldetektor 16 detektieren, vorzugsweise mit unterschiedlichen Verfahren, die Anwesenheit eines Nutzsignals in dem Empfangssignal und geben das Ergebnis dieser Detektion an den Entscheider 17 weiter. Der Entscheider 17 entscheidet basierend auf den Detektionsergebnissen der Signaldetektoren 15 und 16, ob ein Nutzsignal in dem Empfangssignal vorhanden ist, oder nicht. Vorzugsweise führt der Entscheider eine ODER-Verknüpfung durch. D.h. sobald einer der Signaldetektoren 15, 16 die Anwesenheit eines Nutzsignals im Empfangssignal detektiert, entscheidet der Entscheider 17, dass ein Nutzsignal im Empfangssignal vorhanden ist. Basierend auf dem Ergebnis dieser Entscheidung steuert der Entscheider 17 den Stummschalter 12.

Das Empfangssignal wird zusätzlich der Verarbeitungseinrichtung 11' zugeführt, welche es zu einem analogen Audio-Signal weiterverarbeitet. Die Verarbeitungseinrichtung 11' gibt das resultierende Signal an den Eingangsanschluss des Stummschalters 12 weiter. Hat der Entscheider 17 entschieden, dass ein Nutzsignal in dem Empfangssignal enthalten ist, so steuert er den Stummschalter 12 derart, dass das Ausgangssignal der Verarbeitungseinrichtung 11' dem Lautsprecher 13 zugeführt wird. Wurde dagegen durch den Entscheider 17 entschieden, dass kein Nutzsignal in dem Empfangssignal vorhanden ist, so steuert er den Stummschalter 12 derart, dass das Ausgangssignal der Verarbeitungseinrichtung 11' verworfen wird.

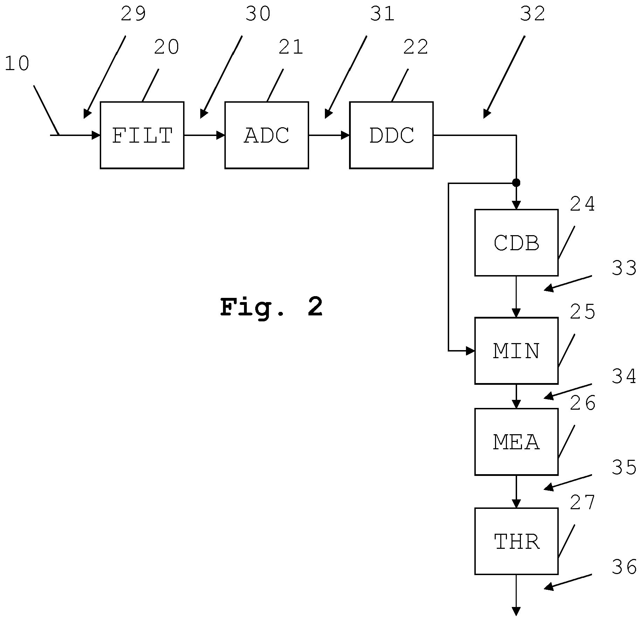

In Fig. 2 ist ein zweites Ausführungsbeispiel der erfindungsgemäßen Rauschsperre gezeigt. Hier dargestellt ist lediglich ein Signaldetektor, welcher beispielsweise dem Signaldetektor 16 aus Fig. 1 entspricht. Mit dem Eingangsanschluss 10 verbunden ist eine Filtereinrichtung 20, welche mit einem Analog-Digital-Wandler 21 verbunden ist. Dieser wiederrum ist mit einem digitalen Frequenzkonvertierer 22 verbunden. Dieser ist mit einer Verzögerungseinrichtung 24 verbunden. Die Verzögerungseinrichtung 24 ist mit einem Minimum-Detektor 25 verbunden, welcher mit einer Mittelwertbildungs-Einrichtung 26 verbunden ist. Diese wiederum ist mit einem Vergleicher 27 verbunden ist. Zusätzlich ist der Ausgang des Frequenzkonvertierers 22 mit dem Minimum-Detektor 25 verbunden.

An dem Eingangsanschluss 10 wird ein Empfangssignal 29 zugeführt. Das Empfangssignal 29 wird durch die Filtereinrichtung 20 gefiltert und als gefiltertes Empfangssignal 30 an den Analog-Digital-Konverter 21 übertragen. Die Filterung besteht dabei aus einer Zwischenfrequenz-Filterung. Der Analog-Digital-Wandler 21 digitalisiert das Signal 20 zu einem digitalisierten gefilterten Empfangssignal 31. Dieses wird dem digitalen Frequenzkonverter 22 zugeführt, welcher es ins Basisband transformiert und als digitales Basisbandsignal 32 an die Filtereinrichtung überträgt. Dabei wird von einem FIR-Filter innerhalb des Frequenzkonverters 22 eine Kanalselektion durchgeführt. Durch die Filterung in dem FIR-Filter innerhalb des Frequenzkonvertierers 22 und durch die Filterung in der Filtereinrichtung 20 wird eine zeitliche Verbreiterung von Störimpulsen bewirkt, da die Bandbreite des Signals reduziert wird.

Das digitale Basisbandsignal 32 wird der Verzögerungseinrichtung 24 zugeführt, welche das Signal um eine Verzögerungszeit Δt verzögert. Das verzögerte, digitale Basisbandsignal 33 wird dem Minimum-Detektor 25 zugeführt. Gleichzeitig wird dem Minimum-Detektor 25 auch das digitale Basisbandsignal 32 zugeführt. Der Minimum-Detektor 25 bestimmt im Zeitbereich das jeweilige Minimum der beiden Signale 32, 33 und erzeugt hierauf basierend ein Minimum-Signal 34. Das Minimum-Signal 34 wird anschließend der Mittelwertbildungs-Einrichtung 26 zugeführt, welche einen zeitlichen Mittelwert des Signals bildet. Die Energie des Signals wird dadurch über der Zeit verteilt.

Das resultierende Mittelwert-Signal 35 wird dem Vergleicher 26 zugeführt, welcher es mit einem Schwellwert vergleicht. Überschreitet das Mittelwert-Signal 35 den Schwellwert, so wird dies als Anwesenheit eines Nutzsignals im Empfangssignal detektiert. Unterschreitet jedoch das Mittelwert-Signal 35 den Schwellwert, so wird dies als Abwesenheit eines Nutzsignals im Empfangssignal detektiert. Der Vergleicher 26 gibt als Ausgangssignal ein binäres Entscheidungssignal 36 aus.

In Fig. 3a ist das Eingangssignal 29 aus Fig. 2 dargestellt. Hier enthält das Signal eine Reihe von Störimpulsen hoher Amplitude und sehr geringer zeitlicher Ausdehnung. Jeder Impuls hat hier beispielsweise eine Dauer von 10ps und einen zeitlichen Abstand von 1ms. Die Amplitude der Impulse entspricht dabei im Beispiel 3mV. Fig. 3a zeigt zusätzlich einen Schwellwert 11, welcher zur Detektion eines Nutzsignals im Empfangssignal herangezogen wird. Ohne die erfindungsgemäße Signalverarbeitung würde jeder einzelne Störimpuls als Nutzsignal interpretiert werden, da er den Schwellwert überschreitet.

In Fig. 3b ist das digitale Basisbandsignal 32 aus Fig. 2 gezeigt. Die Filterung durch das FIR-Filter innerhalb des Frequenzkonvertierers 22 und die Filterung durch die Filtereinrichtung 20 haben zu einer Verteilung der Energie eines jeden Störimpulses über der Zeit gesorgt, da das Eingangssignal 29 in seiner Bandbreite begrenzt wurde. Die Impulse sind somit etwas breiter geworden. In der hier gewählten Darstellung sind die Impulse übertrieben breit dargestellt. In der Realität werden sie um einen geringen Faktor, z. B. 10 oder mehr, breiter als in dem ursprünglichen Eingangssignal 29.

In Fig. 3c ist nun das zeitlich verzögerte, digitale Basisband-Signal 33 dargestellt. Das Signal entspricht exakt dem Signal 32, ist jedoch zeitlich verschoben.

In Fig. 3d sind nun das digitale Basisbandsignal 32 und das zeitlich verschobene digitale Basisband-Signal 33 dargestellt. Deutlich erkennbar ist hier die Verzögerungszeit Δt. Sie entspricht hier 60 µs. Deutlich erkennbar ist, dass die Signale 32, 33 an ihren Spitzen nicht überlappen, im Bereich ihrer Basis jedoch überlappen.

In Fig. 3e ist das resultierende Mittelwert-Signal 35 dargestellt. Dieses Signal entspricht den Überlappungsbereichen der Signale 33 und 34 aus Fig. 3d welche zusätzlich über der Zeit gemittelt wurden. Zusätzlich ist hier erneut der Schwellwert 11 dargestellt. Deutlich erkennbar ist, dass das Minimum-Signal den Schwellwert 11 an keiner Stelle überschreitet. Somit werden sämtliche Störimpulse aus Fig. 3a nun nicht länger als Nutzsignal detektiert.

Ein tatsächliches Nutzsignal dagegen könnte auf diese Art und Weise nicht herausgefiltert werden, da es nicht lediglich aus sehr kurzen Störimpulsen besteht. Das Nutzsignal wird durch das hier gezeigte Verfahren darüber hinaus grundsätzlich nicht verändert, da es nicht durch die Verzögerungseinrichtung 24 und den Minimum-Detektor 25 läuft.

Fig. 4 zeigt ein Ausführungsbeispiel des erfindungsgemäßen Verfahrens. In einem ersten Schritt 40 wird ein Empfangssignal gefiltert. Diese Filterung dient einer Vorverarbeitung. Es werden z.B. Signalanteile außerhalb des Nutzbandes entfernt. In einem zweiten Schritt 41 erfolgt eine Digitalisierung des gefilterten Signals. Das digitale Signal wird anschließend in einem dritten Schritt 42 einer Frequenzverschiebung unterzogen. Hierbei wird das Signal in das Basisband transformiert. Durch die Bandbegrenzung des Signals bei der Filterung im ersten Schritt 40 und bei der Frequenzverschiebung werden einzelne Störimpulse über den Zeitbereich verteilt.
In einem vierten Schritt 43 wird eine Verzögerung des resultierenden Signals um eine Verzögerungszeit Δt durchgeführt. Die Verzögerungszeit Δt ist dabei in der Größenordnung der Breite zu entfernender Störimpulse.

In einem fünften Schritt 44 wird das Minimum des verzögerten und des nichtverzögerten Signals gebildet. Hierdurch werden hohe Signalspitzen aus dem Signal entfernt. In einem sechsten Schritt 45 wird eine Mittelung durchgeführt. D.h. die Energie des Signals wird über der Zeit verteilt.

Abschließend wird in einem siebten Schritt 46 das resultierende Signal mit einem Schwellwert verglichen. Unterschreitet das Signal den Schwellwert, wird dies als Abwesenheit eines Nutzsignals im Empfangssignal detektiert. Überschreitet dagegen das Minimum-Signal den Schwellwert, so wird dies als Anwesenheit eines Nutzsignals im Empfangssignal detektiert.

Hier nicht dargestellt sind die weiteren Schritte der Signalverarbeitung des Empfangssignals und der Freischaltung bzw. Sperrung des Ausgangssignals bei Anwesenheit bzw. Abwesenheit eines Nutzsignals.

Die Erfindung ist nicht auf das dargestellte Ausführungsbeispiel beschränkt. Wie bereits erwähnt, können mehrere unterschiedliche Signaldetektoren eingesetzt werden.

## Patentansprüche

1. Rauschsperre für Hochfrequenzempfänger, mit einem ersten Signaldetektor (16), welcher ausgebildet ist, um die Anwesenheit eines Nutzsignals in einem Empfangssignal (29) zu detektieren,
wobei der erste Signaldetektor (16) eine Verzögerungseinrichtung (24) beinhaltet, welche ausgebildet ist, um ein von dem Empfangssignal (29) abgeleitetes Signal (32) um eine Verzögerungszeit zu verzögern,
**dadurch gekennzeichnet,**
**dass** der erste Signaldetektor (16) einen Minimum-Detektor (25) beinhaltet, welcher ausgebildet ist, um ein Minimum-Signal (34) als Minimum des von dem Empfangssignal abgeleiteten Signals (32) und des verzögerten von dem Empfangssignal abgeleiteten Signals (33) zu bilden,
**dass** die Verzögerungszeit zwischen 20ps und 200ps liegt und dass der erste Signaldetektor (16) weiterhin eine Mittelwertbildungs-Einrichtung (26) beinhaltet, welche ausgebildet ist, um das Minimum-Signal (34) zeitlich zu mitteln und so ein Mittelwert-Signal (35) zu erzeugen, dass der erste Signaldetektor (16) weiterhin einen Vergleicher (27) beinhaltet, welcher ausgebildet ist, um das Mittelwert-Signal (35) mit einem ersten Schwellwert zu vergleichen, wobei ein Überschreiten des ersten Schwellwerts eine Anwesenheit eines Nutzsignals im Empfangssignal (29) anzeigt.

2. Rauschsperre nach Anspruch 1,
**dadurch gekennzeichnet,**
**dass** die Verzögerungszeit zwischen 50ps und 100µs liegt, und
**dass** die Verzögerungszeit in Abhängigkeit einer Breite zu unterdrückender Störimpulse oder in Abhängigkeit einer Modulationsart des Empfangssignals (29) einstellbar ist.

3. Rauschsperre nach einem der Ansprüche 1 bis 2,
**dadurch gekennzeichnet,**
**dass** die Rauschsperre zumindest eine Filtereinrichtung (26) beinhaltet, welche ausgebildet ist, um das Minimum-Signal (34) zu filtern.

4. Rauschsperre nach einem der Ansprüche 1 bis 3,
**dadurch gekennzeichnet,**
**dass** die Rauschsperre weiterhin einen zweiten Signaldetektor (15) beinhaltet, welcher ausgebildet ist,
um anhand eines Überschreitens eines zweiten Schwellwerts durch ein Signal-Rausch-Verhältnis des Empfangssignals (29) eine Anwesenheit eines Nutzsignals im Empfangssignal (29) zu detektieren.

5. Rauschsperre nach Anspruch 4,
**dadurch gekennzeichnet,**
**dass** die Rauschsperre weiterhin einen Entscheider (17) beinhaltet, welcher ausgebildet ist, um zu entscheiden, dass ein Nutzsignals im Empfangssignal (29) vorhanden ist, wenn zumindest ein Signaldetektor (15, 16) ein Nutzsignals im Empfangssignal (29) detektiert.

6. Rauschsperre nach einem der Ansprüche 1 bis 5,
**dadurch gekennzeichnet,**
**dass** die Rauschsperre weiterhin einen Stummschalter (12) beinhaltet, welcher ausgebildet ist, um ein von dem Empfangssignal (29) abgeleitetes Signal auf einen Signalausgang zu schalten, wenn zumindest ein Signaldetektor (15, 16) eine Anwesenheit eines Nutzsignals im Empfangssignal (29) anzeigt.

7. Verfahren zur Rausch-Sperrung in einem Hochfrequenzempfänger, wobei die Anwesenheit eines Nutzsignals in einem Empfangssignal (29) detektiert wird, wobei ein von dem Empfangssignal (29) abgeleitetes Signal (32) um eine Verzögerungszeit verzögert wird,
**dadurch gekennzeichnet,**
**dass** ein Minimum-Signal (34) als Minimum des von dem Empfangssignal abgeleiteten Signals (32) und des verzögerten von dem Empfangssignal abgeleiteten Signals (33) gebildet wird,
**dass** die Verzögerungszeit zwischen 20ps und 200ps liegt und dass das Minimum-Signal (34) zeitlich gemittelt wird und so ein Mittelwert-Signal (35) erzeugt wird, und
**dass** das Mittelwert-Signal (35) mit einem ersten Schwellwert verglichen wird, wobei ein Überschreiten des ersten Schwellwerts eine Anwesenheit eines Nutzsignals im Empfangssignal (29) anzeigt.

8. Verfahren nach Anspruch 7,
**dadurch gekennzeichnet,**
**dass** die Verzögerungszeit zwischen 50ps und 100µs liegt, und
**dass** die Verzögerungszeit in Abhängigkeit einer Breite zu unterdrückender Störimpulse oder in Abhängigkeit einer Modulationsart des Empfangssignals (29) eingestellt wird.

9. Verfahren nach einem der Ansprüche 7 bis 8,
**dadurch gekennzeichnet,**
**dass** das Minimum-Signal (34) gefiltert wird.

10. Verfahren nach Anspruch 9,
**dadurch gekennzeichnet,**
**dass** eine Mittelung im Zeitbereich durchgeführt wird.

11. Verfahren nach einem der Ansprüche 7 bis 10,
**dadurch gekennzeichnet,**
**dass** anhand eines Überschreitens eines zweiten Schwellwerts durch ein Signal-Rausch-Verhältnis des Empfangssignals (29) eine Anwesenheit eines Nutzsignals im Empfangssignal (29) detektiert wird.

12. Verfahren nach Anspruch 11,
**dadurch gekennzeichnet,**
**dass** entschieden wird, dass ein Nutzsignals im Empfangssignal (29) vorhanden ist, wenn zumindest mittels eines vorgenannten Verfahrens ein Nutzsignal im Empfangssignal (29) detektiert wird.

13. Verfahren nach einem der Ansprüche 7 bis 12,
**dadurch gekennzeichnet,**
**dass** ein von dem Empfangssignal (29) abgeleitetes Signal auf einen Signalausgang geschaltet wird, wenn zumindest mittels eines vorgenannten Verfahrens eine Anwesenheit eines Nutzsignals im Empfangssignal (29) ermittelt wird.

## Claims

1. Squelch device for high frequency receivers, with a first signal detector (16) which is configured to detect the presence of a useful signal in a received signal (29),
wherein the first signal detector (16) comprises a delay unit (24) which is configured to delay a signal (32) derived from the received signal (29) by a delay time,
**characterised in that**
the first signal detector (16) comprises a minimum detector (25) which is configured to form a minimum signal (34) as the minimum of the signal (32) derived from the received signal and of the delayed signal (33) derived from the received signal,
**in that** the delay time lies between 20 µs and 200 µs and **in that** the first signal detector (16) also comprises an average value forming unit (26) which is configured to average the minimum signal with respect to time and thus generate an average value signal (35),
**in that** the first signal detector (16) also comprises a comparator (27) which is configured to compare the average value signal (35) with a first threshold value so that an overshooting of the first threshold value indicates the presence of a useful signal in the received signal (29).

2. Squelch device according to claim 1,
**characterised in that**
the delay time lies between 50 µs and 100 ps, and
**in that** the delay time is adjustable dependent on a width of interference pulses to be suppressed or dependent on a type of modulation of the received signal (29).

3. Squelch device according to one of claims 1 to 2,
**characterised in that**
the squelch device comprises at least one filtering unit (26) which is configured to filter the minimum signal (34) .

4. Squelch device according to one of claims 1 to 3,
**characterised in that**
the squelch device also comprises a second signal detector (15) which is configured to detect the presence of a useful signal in the received signal by reference to an overshooting of a second threshold value by a signal-to-noise ratio of the received signal (29).

5. Squelch device according to claim 4,
**characterised in that**
the squelch device also comprises a discriminator (17) which is configured to decide that a useful signal is present in the received signal (29) when at least one signal detector (15, 16) detects a useful signal in the received signal (29).

6. Squelch device according to one of claims 1 to 5,
**characterised in that**
the squelch device also comprises a muting switch (12) which is configured to switch a signal derived from the received signal (29) to a signal output when at least one signal detector (15, 16) indicates the presence of a useful signal in the received signal (29).

7. Method for squelch in a high frequency receiver, wherein the presence of a useful signal in a received signal (29) is detected, wherein a signal (32) derived from the received signal (29) is delayed by a delay time,
**characterised in that**
a minimum signal (34) is formed as the minimum of the signal (32) derived from the received signal and of the delayed signal (33) derived from the received signal,
**in that** the delay time lies between 20 µs and 200 µs and **in that** the minimum signal (34) is averaged with respect to time and thus an average value signal (35) is generated, and
**in that** the average value signal (35) is compared with a first threshold value so that an overshooting of the first threshold value indicates the presence of a useful signal in the received signal (29).

8. Method according to claim 7,
**characterised in that**
the delay time lies between 50 µs and 100 ps, and
**in that** the delay time is adjustable dependent on a width of interference pulses to be suppressed or dependent on a type of modulation of the received signal (29).

9. Method according to one of claims 7 to 8,
**characterised in that**
the minimum signal (34) is filtered.

10. Method according to claim 9,
**characterised in that**
averaging is carried out in the time domain.

11. Method according to one of claims 7 to 10,
**characterised in that**
the presence of a useful signal in the received signal (29) is detected by reference to an overshooting of a second threshold value by a signal-to-noise ratio of the received signal (29).

12. Method according to claim 11,
**characterised in that**
it is decided that a useful signal is present in the received signal (29) when a useful signal is detected in the received signal (29) by means of at least one method named previously.

13. Method according to one of claims 7 to 12,
**characterised in that**
a signal derived from the received signal (29) is switched to a signal output when the presence of a useful signal in the received signal (29) is determined by means of at least one method named previously.

## Revendications

1. Suppresseur de bruit de fond pour récepteur haute fréquence, comprenant un premier détecteur de signal (16), lequel est conçu pour détecter la présence d'un signal utile dans un signal de réception (29),
dans lequel le premier détecteur de signal (16) comporte un dispositif de retard (24), lequel est conçu pour retarder un signal (32) dérivé du signal de réception (29) d'un temps de retard,
**caractérisé**
**en ce que** le premier détecteur de signal (16) comporte un détecteur de minimum (25), lequel est conçu pour former un signal de minimum (34) en tant que minimum du signal (32) dérivé du signal de réception et du signal (33) dérivé du signal de réception,
**en ce que** le temps de retard est compris entre 20 µs et 200 µs et en ce que le premier détecteur de signal (16) comporte en outre un dispositif de calcul de moyenne (26), lequel est conçu pour calculer la moyenne dans le temps du signal de minimum (34) et pour produire ainsi un signal de moyenne (35),
**en ce que** le premier détecteur de signal (16) comporte en outre un comparateur (27), lequel est conçu pour comparer le signal de moyenne (35) à une première valeur seuil, dans lequel un dépassement de la première valeur seuil indique la présence d'un signal utile dans le signal de réception (29).

2. Suppresseur de bruit de fond selon la revendication 1,
**caractérisé**
**en ce que** le temps de retard est compris entre 50 µs et 100 ps, et
**en ce que** le temps de retard peut être réglé en fonction d'une largeur d'impulsions parasites bloquantes ou en fonction d'un type de modulation du signal de réception (29).

3. Suppresseur de bruit de fond selon l'une quelconque des revendications 1 à 2,
**caractérisé**
**en ce que** le suppresseur de bruit de fond comporte au moins un système de filtre (26), lequel est conçu pour filtrer le signal de minimum (34).

4. Suppresseur de bruit de fond selon l'une quelconque des revendications 1 à 3,
**caractérisé**
**en ce que** le suppresseur de bruit de fond comporte en outre un deuxième détecteur de signal (15), lequel est conçu pour détecter la présence d'un signal utile dans le signal de réception (29) sur la base d'un dépassement d'une deuxième valeur seuil par un rapport signal-bruit du signal de réception (29) .

5. Suppresseur de bruit de fond selon la revendication 4,
**caractérisé**
**en ce que** le suppresseur de bruit de fond comporte en outre un dispositif de décision (17), lequel est conçu pour décider qu'un signal utile est présent dans le signal de réception (29), lorsqu'au moins un détecteur de signal (15, 16) détecte un signal utile dans le signal de réception (29).

6. Suppresseur de bruit de fond selon l'une quelconque des revendications 1 à 5,
**caractérisé**
**en ce que** le suppresseur de bruit de fond comporte en outre un commutateur de silencieux (12), lequel est conçu pour commuter un signal dérivé du signal de réception (29) sur une sortie de signal, lorsqu'au moins un détecteur de signal (15, 16) indique la présence d'un signal utile dans le signal de réception (29).

7. Procédé pour supprimer un bruit de fond dans un récepteur haute fréquence, dans lequel la présence d'un signal utile est détectée dans un signal de réception (29), dans lequel un signal (32) dérivé du signal de réception (29) est retardé d'un temps de retard,
**caractérisé**
**en ce qu'**un signal de minimum (34) est formé en tant que minimum du signal (32) dérivé du signal de réception et du signal (33) dérivé du signal de réception et retardé,
**en ce que** le temps de retard est compris entre 20 µs et 200 µs et en ce la moyenne du signal de minimum (34) est calculé dans le temps et un signal de moyenne (35) est ainsi produit, et
**en ce que** le signal de moyenne (35) est comparé à une première valeur seuil, dans lequel un dépassement de la première valeur seuil indique la présence d'un signal utile dans le signal de réception (29).

8. Procédé selon la revendication 7,
**caractérisé**
**en ce que** le temps de retard est compris entre 50 µs et 100 ps, et
**en ce que** le temps de retard peut être réglé en fonction d'une largeur d'impulsions parasites bloquantes ou en fonction d'un type de modulation du signal de réception (29).

9. Procédé selon l'une quelconque des revendications 7 à 8,
**caractérisé**
**en ce que** le signal de minimum (34) est filtré.

10. Procédé selon la revendication 9,
**caractérisé**
**en ce qu'**une moyenne est calculée dans le domaine temporel.

11. Procédé selon l'une quelconque des revendications 7 à 10,
**caractérisé**
**en ce que** la présence d'un signal utile dans le signal de réception (29) est détectée sur la base d'un dépassement d'une deuxième valeur seuil par un rapport signal-bruit du signal de réception (29).

12. Procédé selon la revendication 11,
**caractérisé**
**en ce qu'**il est décidé qu'un signal utile est présent dans le signal de réception (29) lorsqu'un signal utile est détecté dans le signal de réception (29) au moins au moyen d'un procédé précédemment cité.

13. Procédé selon l'une quelconque des revendications 7 à 12,
**caractérisé**
**en ce qu'**un signal dérivé du signal de réception (29) est commuté sur une sortie de signal lorsque la présence d'un signal utile dans le signal de réception (29) est déterminée au moins au moyen d'un procédé précédemment cité.
